# EUROPÄISCHE PATENTANMELDUNG

(11) **EP 1 063 712 A2**
(43) Veröffentlichungstag der Anmeldung: **27.12.2000**
(21) Anmeldenummer: 00810470.5
(22) Anmeldetag: 29.05.2000
(51) Int. Cl.: H01L 39/16

(54) **Hochtemperatursupraleiteranordnung**

(30) Priorität: 25.06.1999 DE 19929277
(71) Anmelder: ABB RESEARCH LTD., 8050 Zürich (CH)
(72) Erfinder: Chen, Makan, Dr., 5405 Baden-Dättwil (CH); Paul, Willi, Dr., 5430 Wettingen (CH)
(74) Vertreter: ABB Patent Attorneys

(57) **Zusammenfassung**

Die vorliegende Erfindung betrifft eine Hochtemperatursupraleiteranordnung, welche um einen Wärmespeicher (4) ergänzt ist und bei welcher der Supraleiter (10) dadurch kurzzeitig vor übermässiger Erwärmung geschützt ist. Die erfindungsgemässe Anordnung ist insbesondere zur Verwendung in supraleitenden Strombegrenzern geeignet.

Als Wärmespeicher (4) wird ein Faserverbundwerkstoff vorgeschlagen, dessen Polymermatrix ein geeignetes Füllmaterial hoher Wärmekapazität aufweist. Dieser Faserverbundwerkstoff dient somit sowohl der mechanischen wie auch der thermischen Stabilisierung der Supraleiteranordnung.

## Beschreibung

### TECHNISCHES GEBIET

Die Erfindung bezieht sich auf das Gebiet der Hochtemperatursupraleiter. Sie geht aus von einer Hochtemperatursupraleiteranordnung nach dem Oberbegriff des Anspruchs 1.

### STAND DER TECHNIK

In der deutschen Offenlegungsschrift DE 196 34 424 A1 ist eine Hochtemperatursupraleiteranordnung zur Verwendung in einem Strombegrenzer dargestellt. Die Anordnung umfasst eine supraleitende Schicht, eine als elektrischer Bypass ausgebildete Silberschicht, welche mit der supraleitenden Schicht einen Leiterverbund bildet, und eine Faserverbundschicht. Letztere enthält eine Matrix aus Epoxidharz und Glas- oder Kohlefasern als verstärkendes Trägermaterial. Sie dient zur mechanischen Stabilisierung des Leiterverbundes und wird durch Vakuumimprägnieren auf mindestens eine Hauptfläche des Leiterverbundes aufgebracht.

Strombegrenzer auf Hochtemperatursupraleiterbasis werden in ein Kühlmedium, vorzugsweise flüssigen Stickstoff LN₂, eingetaucht. Tritt der Supraleiter im Kurzschlussfall infolge eines Überstromes in den resistiven Zustand über, wird Energie dissipiert und der Supraleiter heizt sich unter Umständen sehr stark auf und benötigt zumindest eine gewisse Zeit, um wieder auf Betriebstemperatur abzukühlen. Die im Kurzschlussfall kurzzeitig entstehende Joulsche Wärme muss also möglichst effizient abgeführt werden. In der obengenannten Anordnung erfolgt die Wärmeleitung zum Kühlmedium hin senkrecht zur Faserverbundschicht. Die Effizienz des Wärmeübergangs in den flüssigen Stickstoff LN₂ lässt aber nach, sobald letzterer zu verdampfen anfängt und sich an der zu kühlenden Oberfläche Blasen oder ein gasförmiger Film bilden, da die spezifische Wärme von Stickstoffgas geringer ist als die Verdampfungswärme von LN₂. Eine unerwünschte Erwärmung des Leiterverbundes bis hin zu einer irreparablen Schädigung des Hochtemperatursupraleiters ist die Folge.

### DARSTELLUNG DER ERFINDUNG

Es ist deshalb Aufgabe der Erfindung, eine Hochtemperatursupraleiteranordnung zu schaffen, bei welcher der Supraleiter bei Belastung durch einen Überstrom vor übermässiger Erwärmung geschützt ist. Diese Aufgabe wird gelöst durch eine Hochtemperatursupraleiteranordnung mit den Merkmalen des Patentanspruchs 1.

Kern der Erfindung ist es, bei einer Hochtemperatursupraleiteranordnung der eingangs genannten Art eine wärmespeichernde Schicht in Kontakt mit dem Supraleiter vorzusehen. Diese nimmt die durch einen kurzzeitigen Überstrom im Supraleiter erzeugte Wärme auf und gibt sie danach an das Kühlmedium ab. Dadurch erwärmt sich der Supraleiter weniger stark und kühlt sich entsprechend schneller wieder auf seine Betriebstemperatur ab.

Gemäss einer ersten Ausführungsform ist eine bei Hochtemperatursupraleiteranordnungen ursprünglich zur mechanischen Stabilisierung eingeführte Schicht aus Faserverbundwerkstoff als Wärmespeicher ausgebildet.

Gemäss einer zweiten Ausführungsform ist dieser Schicht zur Erhöhung der Wärmekapazität ein Füllmaterial mit einer hohen spezifischen Wärme beigegeben. Dieses Füllmaterial wird der Polymermatrix beigemischt und durchdringt das Trägergewebe des Verbundwerkstoffs.

In einer weiteren Ausführungsform werden das Träger- und Füllmaterial so gewählt, dass der Wärmeleitungskoeffizient des resultierenden Faserverbundwerkstoffes möglichst gross ist. Damit wird erreicht, dass im Supraleiter lokal und kurzzeitig erzeugte Wärme in der als Wärmespeicher konzipierten Schicht gleichzeitig etwas verteilt, d.h. vom Ort ihrer Entstehung weggeführt werden kann.

In einer weiteren Ausführungsform werden das Träger- und Füllmaterial dahingehend optimiert, dass der Wärmeausdehnungskoeffizient des resultierenden Faserverbundwerkstoffes möglichst klein ist. Dadurch kann die thermische Kontraktion des ganzen Verbundwerkstoffes und somit der Stress auf den Supraleiter beim Abkühlen auf dessen Betriebstemperatur verringert werden.

Faserverbundwerkstoffe mit einem Aufbau ähnlich dem vorgehend genannten sind schon aus der Patentschrift EP 0 257 466 B1 bekannt. Dort ist ein Laminat aus einer Metallschicht und einer Schicht aus einem ausgehärteten Polymermatrix-Verbundmaterial offenbart, welches beispielsweise zur Kühlung von auf einer Leiterplatte angebrachten elektronischen Bauteilen dient. In die Verbundmaterialschicht ist ein verstärkendes, wärmeleitendes Material geringer thermischer Ausdehnung in Form von Teilchen, Fasern oder Geweben eingebracht. Diese Schicht dient der Wärmeleitung zwischen der Wärmequelle (den elektronischen Bauteilen) und der Wärmesenke (Metallschicht) sowie zum Angleich der thermischen Ausdehnungskoeffizienten von Leiterplatte und Metallschicht. Im Gegensatz dazu wird in der vorliegenden Erfindung ein derartiger Faserverbundwerkstoff selbst als Wärmespeicher eingesetzt und fungiert nicht bloss als Wärmeleiter und/oder elektrischer Isolator.

### KURZE BESCHREIBUNG DER FIGUREN

Nachfolgend wird die Erfindung anhand von Ausführungsbeispielen im Zusammenhang mit den Zeichnungen näher erläutert.

Fig.1a zeigt einen Schnitt durch eine Hochtemperatursupraleiteranordnung nach dem Stand der Technik und Fig.1b einen solchen gemäss der Erfindung.

Fig.2 zeigt eine perspektivische Darstellung eines Faserverbundwerkstoffes nach einer bevorzugten Ausführungsform der Erfindung.

Die in den Zeichnungen verwendeten Bezugszeichen sind in der Bezugszeichenliste zusammengefasst. Grundsätzlich sind gleiche Teile mit denselben Bezugszeichen versehen.

### WEGE ZUR AUSFÜHRUNG DER ERFINDUNG

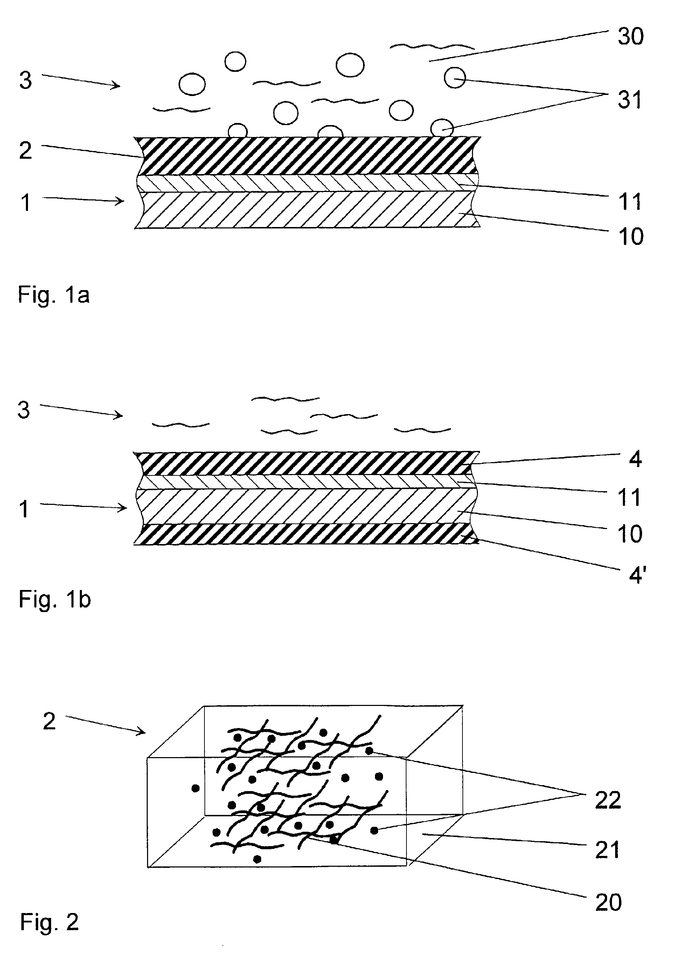

In Fig.1a ist ein Ausschnitt aus einem Querschnitt durch eine Supraleiteranordnung, wie sie beispielsweise in Strombegrenzern Verwendung findet, nach dem Stand der Technik dargestellt. Ein Hochtemperatursupraleiter 10 ist mit einer elektrischen Bypassschicht 11 flächenhaft verbunden und bildet mit dieser einen Leiterverbund 1. An eine Hauptfläche des Leiterverbundes 1 anschliessend ist eine Schicht aus Faserverbundwerkstoff 2 zur mechanischen Stabilisierung des Leiterverbundes 1 angebracht. Die ganze Anordnung wiederum ist in flüssigen Stickstoff LN₂ 30 eingetaucht oder von einem anderen Kühlmedium 3 umgeben.

Häufig ist aufgrund der Ausrichtung der Fasern des Trägergewebes die Wärmeleitfähigkeit von Faserverbundwerkstoffen 2 in der Ebene des Gewebes ausgeprägter. Bei einer Anordnung wie in Fig.la gezeigt gilt es jedoch, die im Supraleiter 10 entstehende Joulsche Wärme senkrecht zum Faserverbund 2 abzuleiten. Zudem bilden sich am Übergang zwischen Faserverbundwerkstoff 2 und dem daran anschliessenden flüssigen Stickstoff LN₂ 30 aufgrund der bescheidenen Verdampfungswärme des Letztgenannten Blasen aus gasförmigem Stickstoff 31, wodurch die Weiterleitung der Wärme nochmals behindert wird und sich der Leiterverbund 1 quasiadiabatisch erwärmt.

Fig.1b zeigt eine erfindungsgemässe Supraleiteranordnung mit einem Leiterverbund 1 und einer als Wärmespeicher ausgebildeten Schicht 4, welche in flächenhaftem Kontakt mit einer Hauptfläche des Leiterverbundes 1 und dem Kühlmedium 3 steht. In diesem Ausführungsbeispiel ist die wärmespeichernde Schicht 4 auf der Bypass-Seite des Leiterverbundes 1 angeordnet. Obengenanntem Problem wird abgeholfen, indem zumindest ein Teil der während einer kurzzeitigen Überbelastung des Leiterverbundes 1 dissipierte Wärme vorübergehend von dem Wärmespeicher 4 aufgenommen wird. Die während der Überbelastung des Leiterverbundes 1 nicht an das Kühlmedium 3 abgeführte und im Wärmespeicher 4 zwischengespeicherte (gepufferte) Energie wird nach Beendigung des Kurzschlusses, d.h. nach wenigen Wechselstromperioden, an das Kühlmittel 3 abgegeben. Somit erwärmt sich der Supraleiter bei gleicher Wärmeerzeugung weniger stark und kühlt entsprechend schneller wieder auf Betriebstemperatur ab.

Der Leiterverbund 1 kann selbstverständlich noch zusätzliche Schichten aufweisen, oder es können weitere Leiterverbunde, durch elektrisch isolierende Schichten vom erstem Leiterverbund 1 getrennt, vorgesehen sein. Selbstverständlich sind auch zusätzliche wärmespeichernde Schichten 4', beispielsweise auf der einer ersten Wärmesenke 4 gegenüberliegenden Seite des Leiterverbundes 1, möglich.

Die wärmespeichernde Schicht 4 ist aus einem Faserverbundwerkstoff gebildet. Derartige Faserverbundwerkstoffe bestehen aus einer gehärteten Polymermatrix und einem Fasernetzwerk zur mechanischen Verstärkung. Als verstärkende Komponente sind heute üblicherweise Glas- Kohlenstoff- oder Aramidfasern in Form von unidirektional abgelegten oder verwobenen Fasern eingesetzt. Die Matrixsysteme sind vorzugsweise dreidimensional vernetzende Duroplaste und basieren beispielsweise auf Epoxid-, Silizium- oder Polyesterharzen. Sogenannte Prepregs sind mit derartigen Harzformulierungen vorimprägnierte und eventuell vorgehärtete Fasergebilde (zwei- oder dreidimensionale Trägermaterialien), die sich einfach verformen und anschliessend unter Druck und Temperatur ganz aushärten lassen.

In Fig.2 ist im Schnitt ein derartiger Faserverbundwerkstoff 2 dargestellt. Ein Trägergewebe 20 ist von einer Matrix 21 umgeben, in welche ein Füller 22 in Form von kleinen Teilchen eingebracht ist. Dieser Faserverbundwerkstoff 2 selbst ist bei geeigneter Wahl von Träger 20 und Füllstoff 22 als Wärmespeicher, beispielsweise in Form eines Laminats, einsetzbar.

Das Füllmaterial 22 muss dazu eine hohe Wärmekapazität (spezifische Wärme) und vorzugsweise auch eine hohe Wärmeleitfähigkeit aufweisen. "Hoch" in diesem Zusammenhang bedeutet, dass die Wärmekapazität und die Wärmeleitfähigkeit des resultierenden Verbundes 4 gegenüber seinen Eigenschaften ohne Beimischung des Füllmaterials 22 erhöht sein muss. Das Füllmaterial 22 muss sich zudem in der Polymermatrix 21 gut verteilen lassen. Vorzugsweise weist es keinen zu grossen Teilchendurchmesser auf, damit das Matrix-Füllmaterial-Gemisch das Trägermaterial 20 gut infiltriert und benetzt und keine Poren entstehen. Bevorzugt ist der Volumenanteil relativ hoch, damit die Wärmekapazität des Verbundes effizient erhöht werden kann. Der Totalgehalt an Träger- und Füllmaterial ist vorzugsweise grösser als 0.5. Unter Ausnutzung des Perkolationseffektes lässt sich die Wärmeleitfähigkeit ab einer gewissen Teilchenkonzentration zusätzlich steigern. Je nach den gewünschten Eigenschaften des Verbundes lassen sich sowohl Träger- wie Füllmaterial aus verschiedenen Fasertypen respektive Pulvermaterialien zusammenmischen.

Als Trägermaterial zur mechanischen Verstärkung des Verbundwerkstoffes 2 und somit zur mechanischen Stabilisierung des Leiterverbundes 1 lassen sich Fasern aus Glas oder Kohlenstoff einsetzen. Diese sind möglicherweise nur in einer Richtung ausgerichtet oder bilden ein Gewebe 20 oder gar ein dreidimensionales Netzwerk. Der Volumenanteil des Trägermaterials am Verbund beträgt zwischen 0.1 und 0.5. Um die gewünschten thermischen Eigenschaften des Verbundes zu unterstützen, werden vorzugsweise Fasern aus Aluminiumoxid (Al₂O₃) oder Siliziumcarbid (SiC) gewählt.

Der Faserverbundwerkstoff wird bei Raumtemperatur mit dem Leiterverbund verklebt, dann ausgehärtet und anschliessend auf die Betriebstemperatur des Supraleiters abgekühlt. Die dabei durch die unterschiedlichen Kontraktionen entstehenden Druckspannungen auf die Supraleiterkeramik werden verringert, wenn der thermische Ausdehnungskoeffizient des Faserverbundwerkstoffes möglichst gering ist. Dies wird erreicht durch eine gezielte Auswahl des Träger- und des Füllmaterials, welche zu diesem Zweck einen geringen Wärmeausdehnungskoeffizienten aufweisen sollen.

Der Faserverbundwerkstoff wird hauptsächlich in Form von dünnen Platten eingesetzt. Diese werden als sogenannte Prepreg-Platten vorbereitet, indem das gewünschte Füllmaterial der Polymermatrix beigemischt und damit das Trägergewebe imprägniert wird. Prepreg-Platten sind bereits vorgehärtet, bleiben aber noch gut verformbar und werden je nach Art der Polymermatrix unter Druck und/oder Hitze in ihrer endgültigen Form ausgehärtet. Dabei bildet sich eine ausgezeichnete Adhäsionsbindung zwischen dem Faserverbundwerkstoff und dem daran anschliessenden Material, d.h. im vorliegenden Fall dem Leiterverbund.

Als Füller geeignet ist beispielsweise Aluminiumoxid Al₂O₃ mit einer spezifischen Wärme c von 3.35 J/Kcm³ bei Raumtemperatur. Durch Zugabe dieses Pulvers erhöht sich die spezifische Wärme des Verbundes bis auf 1.3 J/K cm³. Andere in Frage kommende pulverförmige Füllmaterialien sind Siliziumkarbid SiC (c= 3.35 J/Kcm³) oder Aluminiumsilicate mit einem hohen Anteil an Al₂O₃ (c= 3 J/Kcm³). Soll gleichzeitig die Wärmeleitfähigkeit verbessert werden, bietet sich auch Kohlenstoff C oder Aluminiumnitrid AlN mit einem Wärmeleitkoeffizienten von 180 W/Km bei Raumtemperatur an. Die Wärmeleitfähigkeit des Verbundes wird durch Zugabe von ausreichend AlN von 0.25 W/Km auf über 1 W/Km gesteigert.

Ein Strombegrenzer umfasst im Allgemeinen eine Supraleiteranordnung der hier vorgestellten Art in Form von mehreren Bahnen oder Abschnitten endlicher Breite, welche parallel zueinander verschoben sind. Zur Vergleichmässigung oder Schwächung des elektrischen Feldes zwischen zwei Supraleiterabschnitten oder einem Supraleiter und einer geerdeten Abschirmung wird in die Polymermatrix ein pulverförmiger Füllstoff mit einer gegenüber dem Material der Matrix hohen Dielektrizitätskonstanten eingebettet. Sehr geeignet dazu ist beispielsweise Russ (carbon black), durch welchen dem Verbund halbleitende Eigenschaften verleihen werden können.

Unter Verwendung eines geeigneten Füllmaterials ergibt sich somit ein Faserverbundwerkstoff, der sich durch seine mechanische Festigkeit und eine erhöhte Wärmekapazität auszeichnet. Er ist somit geeignet für eine Anwendung bei tiefen Temperaturen, insbesondere zur thermischen Stabilisierung von Hochtemperatursupraleitern.

### BEZUGSZEICHENLISTE

1 Leiterverbund
10 Supraleiter
11 Bypass
2 Faserverbundwerkstoff
20 Trägergewebe
21 Polymermatrix
22 Füllmaterial
3 Kühlmedium
30 flüssiger Stickstoff LN₂
31 gasförmiger Stickstoff
4 Wärmespeicher

## Patentansprüche

1. Hochtemperatursupraleiteranordnung mit einem Leiterverbund (1) aus einer supraleitenden Schicht (10) und einer elektrischen Bypass-Schicht (11), dadurch gekennzeichnet, dass eine wärmespeichernde Schicht (4) mit einer Hauptfläche des Leiterverbundes (1) in Kontakt steht.

2. Hochtemperatursupraleiteranordnung nach Anspruch 1, dadurch gekennzeichnet, dass die wärmespeichernde Schicht (4) aus einem Faserverbundwerkstoff (2) mit einer Polymermatrix (21) und einem mechanisch verstärkenden Trägermaterial (20) gebildet ist.

3. Hochtemperatursupraleiteranordnung nach Anspruch 2, dadurch gekennzeichnet, dass der Polymermatrix (21) ein Füllmaterial (22) mit einer Wärmekapazität, welche höher ist als die Wärmekapazität der Polymermatrix (21), beigemischt ist.

4. Hochtemperatursupraleiteranordnung nach Anspruch 3, dadurch gekennzeichnet, dass das Trägermaterial (20) und das Füllmaterial (22) einen Wärmeleitungskoeffizienten aufweisen, welcher höher ist als der Wärmeleitungskoeffizient der Polymermatrix (21).

5. Hochtemperatursupraleiteranordnung nach Anspruch 3, dadurch gekennzeichnet, dass das Trägermaterial (20) und das Füllmaterial (22) einen Wärmeausdehnungskoeffizienten aufweisen, welcher kleiner ist als der Wärmeausdehnungskoeffizient der Polymermatrix (21).

6. Hochtemperatursupraleiteranordnung nach Anspruch 3, dadurch gekennzeichnet, dass der Polymermatrix (21) ein Füllmaterial mit einer Dielektrizitätskonstanten, welche höher ist als die Dielektrizitätskonstante der Polymermatrix (21), beigemischt ist.

7. Hochtemperatursupraleiteranordnung nach einem der Ansprüche 3 bis 6, dadurch gekennzeichnet, dass der Volumenanteil des Trägermaterials (20) im Verbund zwischen 0.1 und 0.5 beträgt.

8. Hochtemperatursupraleiteranordnung nach Anspruch 7, dadurch gekennzeichnet, dass der Volumenanteil von Träger- und Füllmaterial im Verbund mindestens 0.5 beträgt.

9. Hochtemperatursupraleiteranordnung nach einem der Ansprüche 3 bis 6, dadurch gekennzeichnet, dass das Füllmaterial keramische Teilchen mit einer spezifischen Wärme von mindestens 3 J/Kcm³ umfasst.

10. Hochtemperatursupraleiteranordnung nach Anspruch 9, dadurch gekennzeichnet, dass das Füllmaterial ein Pulver aus Aluminiumoxid Al₂O₃, Aluminiumnitrid AlN, Siliziumkarbid SiC oder Kohlenstoff C oder Aluminosilikate mit hohem Al₂O₃ Anteil umfasst.

11. Verwendung eines Faserverbundwerkstoffes mit einer Polymermatrix, einem mechanisch verstärkenden Trägermaterial und einem der Polymermatrix zur Erhöhung der spezifischen Wärme des Verbundes beigemischten Füllmaterial als wärmespeicherndes Laminat.
